Europäisches Patentamt

European Patent Office

Office européen des brevets

(19)

(11) Numéro de publication: **0 232 189**
**B1**

(12) **FASCICULE DE BREVET EUROPEEN**

(45) Date de publication du fascicule du brevet: **05.09.90**

(51) Int. Cl.⁵: **G 01 R 33/34**

(21) Numéro de dépôt: **87400010.2**

(22) Date de dépôt: **06.01.87**

(54) **Antenne orbite pour appareil d'imagerie par résonance magnétique nucléaire.**

(30) Priorité: **07.01.86 FR 8600140**

(43) Date de publication de la demande:
**12.08.87 Bulletin 87/33**

(45) Mention de la délivrance du brevet:
**05.09.90 Bulletin 90/36**

(84) Etats contractants désignés:
**DE GB IT NL**

(56) Documents cités:
**EP-A-0 142 077**
**WO-A-84/00214**
**US-A-4 452 250**

**AMERICAN JOURNAL OF NEURO RADIOLOGIE,
vol. 6, mars/avril 1985, pages 193-196, American
Roentgen Ray Society; J.F. SCHENCK et al.:
"Improved MR Imaging of the orbit at 1.5 T with
surface coils"**

(73) Titulaire: **GENERAL ELECTRIC CGR S.A.
100, rue Camille-Desmoulins
F-92130 Issy les Moulineaux (FR)**

(72) Inventeur: **Kopp, Jean-Pierre
THOMSON-CSF SCPI 19, avenue de Messine
F-75008 Paris (FR)**

(74) Mandataire: **Ballot, Paul Denis Jacques
Cabinet Ballot-Schmit 7, rue le Sueur
F-75116 Paris (FR)**

(56) References cited:
**JOURNAL OF MAGNETIC RESONANCE, vol. 62,
1985, pages 397-405, Academic Press, Inc., New
York, US; P. STYLES et al.: "A concentric
surface-coil probe for the production of
homogeneous B1 Fields"**

**Description**

La présente invention a pour objet une antenne pour l'imagerie de l'orbite oculaire par un appareil d'imagerie par résonance magnétique nucléaire. Elle trouve donc plus particulièrement son application dans le domaine médical pour l'examen des yeux. Elle peut néanmoins servir pour examiner d'autres parties du corps humain dont la taille est faible.

Dans un appareil d'imagerie par résonance magnétique nucléaire (RMN) on soumet un corps à examiner à un champ magnétique constant et intense $B_0$. Quand le corps est sous cette influence, on lui applique en outre une excitation radiofréquence. De cette manière on induit une résonance de l'oscillation des moments magnétiques de particules du corps. Après l'excitation, le signal de résonance émis en retour par les particules, quand leurs moments magnétiques tendent à se réaligner avec le champ $B_0$, est mesuré. On traite le signal mesuré pour en extraire des images de coupe des parties examinées.

L'antenne de l'invention est une antenne qui sert essentiellement à prélever, ou détecter, le signal de résonance à mesurer. L'antenne de l'invention est d'un type dit de surface. Des antennes de surface sont des antennes de reception qui sont placées sur les corps à examiner. Elles sont différentes des antennes d'émission qui sont, elles, en général solidaires de l'appareil d'imagerie lui-même. Les antennes de surface étant plus près du corps à examiner que les antennes solidaires de l'appareil captent un signal dont la qualité, ou le rapport signal sur bruit, est meilleur. Un des principaux problèmes posés par la réalisation des antennes concerne leur symétrisation. Ceci signifie que toutes les parties de l'antenne doivent contribuer à la formation du signal détecté avec une égale participation. Si l'antenne n'est pas symétrique on sait qu'elle capte des bruits extérieurs au corps à examiner, ce qui est gênant.

Les solutions connues de symétrisation d'antenne comportent, dans d'autres domaines de la technique, des dispositifs à couplages magnétiques pour équilibrer les contributions des différents parties de l'antenne à l'élaboration du signal détecté. Malheureusement la présence de corps ferromagnétique est prohibée dans un appareil de RMN. En effet la distribution homogène des champs magnétiques dans un tel appareil est rigoureuse : elle conditionne la qualité et la fidelité des images. Par ailleurs les couplages magnétiques évoqués ont une autre fonction : celle d'adapter l'impédance de l'antenne à l'impédance d'une ligne haute fréquence qui sert à véhiculer le signal détecté. Le problème à résoudre est donc celui du remplacement de ces couplages par d'autres moyens.

La présente invention a justement pour objet de proposer des antennes de surface symétrisées, comportant des moyens d'adaptation d'impédance, et particulièrement étudiées pour convenir à l'imagerie des petites régions. Parmi ces petites régions se trouve principalement l'oeil humain. Une antenne, pour l'imagerie de l'orbite oculaire par un appareil de résonance magnétique nucléaire est décrite dans l'article de J. F. SCHENCK et al. intitulé: "IMPROVED MR IMAGING OF THE ORBIT AT 1.5T WITH SURFACE COILS", paru dans: AMERICAN JOURNAL OF NEURO RADIOLOGY, Vol. 6, MARS-AVRIL 1985, pages 193—196.

L'invention concerne une antenne l'imagerie pour de l'orbite oculaire par un appareil d'imagerie par résonance magnétique nucléaire, caractérisée en ce qu'elle comporte:

un nombre pair de boucles conductrices concentriques en série,

un condensateur d'accord branché entre les extrémités non réunies entre elles de ces boucles,

un circuit de réception à haute impédance d'entrée raccordé entre le point milieu des boucles et une des bornes du condensateur.

L'invention sera mieux comprise à la lecture de la description qui suit et à l'examen des figures qui l'accompagnent. Celles-ci ne sont données qu'à titre indicatif et nullement limitatif de l'invention. Sur les figures les mêmes repères désignent les mêmes éléments. Elles montrent:

figure 1 : un appareil d'imagerie par RMN comportant une antenne selon l'invention;

figure 2 et figure 3 : deux exemples de réalisation d'antenne orbite selon l'invention;

figure 4 : un exemple préféré de réalisation d'un circuit d'adaptation d'impédance.

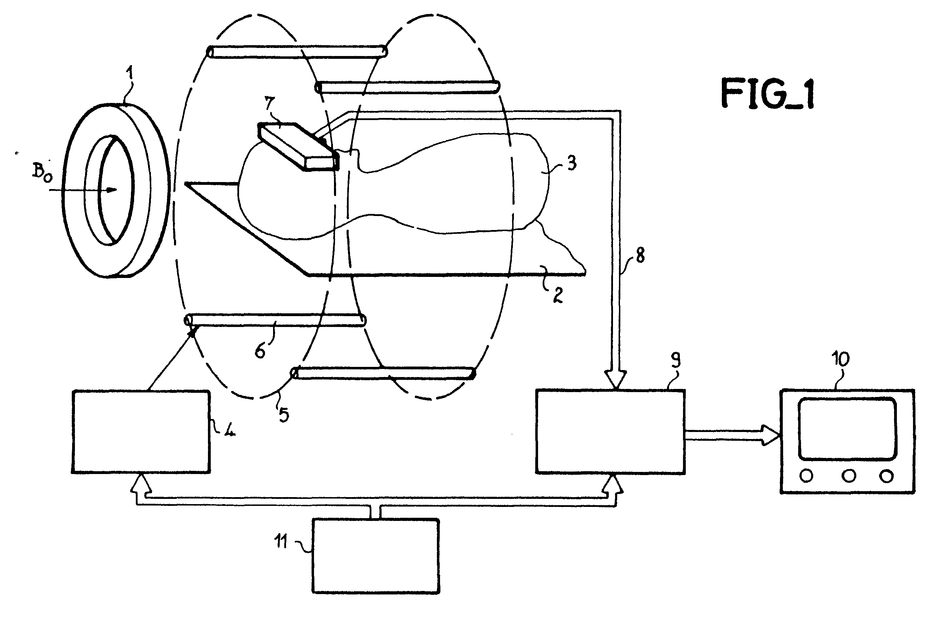

La figure 1 montre un appareil d'imagerie par résonance magnétique nucléaire. Il comporte des moyens 1 pour produire un champ magnétique intense et constant $B_0$. Supporté par un plateau 2, un patient 3 est soumis à l'influence de ce champ. Des moyens générateurs 4 produisent une excitation radiofréquence émise par une antenne d'émission 5 comportant par exemple des barres émettrices telles que 6. Le signal de résonance est prélevé par une antenne orbite 7, par exemple placée au-dessus des yeux du patient 3. Ce signal est acheminé par une ligne 8 haute fréquence vers des moyens de traitement et de mémorisation 9. Les moyens 9 sont reliés à des moyens de visualisation 10 pour visualiser des coupes des régions examinées. Les moyens générateurs 4 et de traitement 9 sont pilotés par un séquenceur 11. L'antenne 7 est une antenne symétrisée et adaptée. La détection du signal, conformément à l'invention, y est faite par un arrangement en nombre pair de boucles conductrices concentriques.

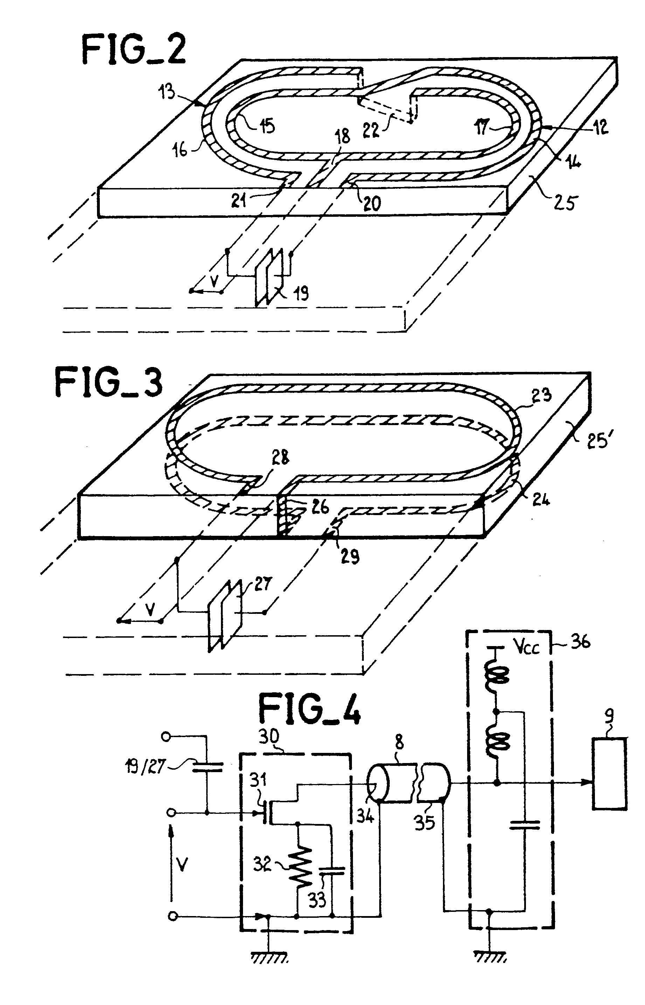

Les figures 2 et 3 montrent des exemples de tels arrangements où le nombre pair vaut 2. Le nombre pair peut être d'autant plus grand que les régions à imager sont plus petites, que la fréquence de résonance du signal reçu est plus faible (à champ $B_0$ faible), et d'une manière plus générale que les inductances des boucles sont plus faibles. Sur la figure 2 deux boucles concentriques 12 et 13 sont dans un même plan, se chevauchent, et chaque boucle comporte un arc extérieur et un arc intérieur : respectivement 14 et 15 et 16 et 17. Le point milieu 18 des boucles correspond à la connexion des deux arcs intérieurs. L'antenne comporte un condensateur 19 branché entre les extrémités non réunies entre elles 20 et 21 respectivement, des boucles 12 et 13. Un circuit de réception à haute impédance d'entrée est raccordé (V) entre le point milieu 18 des boucles et une des bornes de la capacité 19 : par exemple la borne 12. Le chevauchement des boucles 12 et 13 est organisé au moyen d'un pont 22 qui permet l'imbrication des passages arcs extérieurs-arcs intérieurs de chaque boucle. Une couche isolante est interposée à l'endroit du pont 22 entre les conducteurs de chaque boucle. L'antenne a la forme générale d'une ellipse, ou éventuellement d'un cercle. Le point milieu 18 et le pont 22 se trouvent diamètralement opposés l'un de l'autre selon un axe de symétrie de cette antenne. Les boucles sont supportées par un support 25. Ce support peut être en un matériau pour circuit imprimé où les boucles ont été gravées.

La figure 3 montre une autre représentation de l'antenne dans laquelle deux boucles 23, 24, concentriques, sont placées de part et d'autre d'un support isolant 25'. Le support isolant peut ici être un support pour un circuit imprimé double face. Les boucles 23 et 24 sont en série l'une de l'autre et sont reliées à leur point milieu 26 par une connexion qui traverse le support 25'. Un condensateur 27 est branché entre les extrémités 28 et 29 non reliées entre elles des boucles 23 et 24 respectivement. Le récepteur est raccordé entre le point milieu 26 et une des bornes du condensateur 27 : par exemple la borne 28. La présence des condensateurs 19 dans le cas de la figure 2 et 27 dans le cas présent, se justifie par l'utilité de créer un circuit oscillant, à fort coefficoent de surtension, à la fréquence de résonance du signal à mesurer. Dans un cas comme dans l'autre, la concentricité des boucles apporte de plus, par une disposition en vis à vis des surfaces de conducteur de ces boucles, une capacité répartie supplémentaire qui vient renforcer l'efficacité des capacité d'accord de surtension. Il est à remarquer que dans les deux cas l'accord en fréquence est effectué au moyen d'une seule capacité. L'existence de cette seule capacité permet de résoudre un autre problème : celui de n'avoir qu'un seul élément à déterminer. En effet, il est connu pour réduire la captation de bruits diélectriques se produisant dans le corps 3 de disposer les capacités d'accord en différents endroits de la boucle de détection. Pour le réglage il est alors nécessaire que les capacités ainsi choisies soient toutes reglées. Avec une capacité unique, on simplifie ce problème. Et ici la captation des bruits est réduite car la capacité apporte son influence à chacune dex deux boucles de réception en même temps.

Le réglage d'adaptation d'antenne est supprimé grâce à un circuit de réception actif 30. La présence du patient ne modifie pas la fréquence d'accord. La tolérance d'impédance d'entrée par rapport au facteur de bruit est alors grande. Le réglage d'accord de fréquence suffit donc à lui seul.

La figure 4 montre un exemple préféré de réalisation du circuit 30 de réception à haute impédance d'entrée placé en cascade entre les points milieu des boucles et l'une des bornes de la capacité d'accord. Ce circuit 30 est un circuit à haute impédance d'entrée pour ne pas déséquilibrer l'antenne. En effet, dans les deux cas, une des boucles est chargée par un circuit ouvert d'impédance infinie (boucle 12 et boucle 24), alors que l'autre est chargée par le récepteur. Comme l'impédance d'entrée de ce dernier est élevée, il n'y a pas de déséquilibre. Le circuit de réception 30 comporte essentiellement un transistor à effet de champ 31 (FET) monté en émetteur commun par une résistance de polarisation 32 et par un condensateur de découplage 33. Le transistor 31 reçoit le signal détecté sur sa grille et le transmet, amplifié, sur l'âme 34 d'un câble coaxial 35 formant la ligne haute fréquence 8 (figure 1). Le circuit 30 effectue donc l'adaptation d'impédance de l'antenne. Un circuit d'alimentation 36 permet l'application d'une tension de polarision $V_{CC}$ au transistor 31 en empruntant également l'âme 34. Le circuit d'alimentation 36 est d'un type connu : il comporte des moyens pour être découplé du signal à mesurer. Le signal reçu et amplifié par le circuit 30 est ainsi transmis aux moyens de traitement 9. Mécaniquement, les antennes peuvent être réalisées sur des circuits imprimés, souples ou non, l'ensemble étant enrobé dans une résine souple. Le circuit d'adaptation amplification 30 est de préférence réalisé sur le même support, à proximité immédiate de l'antenne.

La figure 4 montre encore le condensateur 19 (ou 27) placé entre les extrémités des boucles. Les conditions de résonance et de surtension sont définies pour une capacité correspondant à la somme de la capacité répartie, de la capacité du condensateur 19 (ou 27), et de la capacité d'entrée du schéma équivalent alternatif de l'amplificateur 30.

## Revendications

1. Antenne (7) pour l'imagerie de l'orbite oculaire par un appareil (1—11) d'imagerie par résonance magnétique nucléaire, caractérisée en ce qu'elle comporte:

un nombre pair de boucles (12; 13) conductrices, concentriques, en série (18),

un condensateur (19) d'accord branché entre les extrémités (21, 20) non réunies entre elles de ces boucles (12; 13),

et un circuit (30) de réception à haute impédance d'entrée raccordé entre le point milieu (18) des boucles (12; 13) et l'une des bornes du condensateur (19).

2. Antenne selon la revendication 1, caractérisée en ce que le nombre pair vaut 2.

3. Antenne selon la revendication 2, caractérisée en ce que les deux boucles (12; 13) sont contenues dans un même plan, se chevauchent, chaque boucle (12; 13) comportant un arc extérieur (14; 16) et un arc intérieur (15; 17) le point milieu (18) des boucles correspondant à la connexion des deux arcs intérieurs (15; 17).

4. Antenne selon la revendication 2, caractérisée en ce que les boucles (23; 24) sont superposées et sont placées à l'aplomb l'une de l'autre de part et d'autre d'une plaque support (25′).

5. Antenne selon l'une quelconque des revendications 1 à 4, caractérisée en ce que le circuit (30) de réception comporte un transistor (31) à effet de champ monté en émetteur commun.

6. Antenne selon la revendication 5, caractérisée en ce que le transistor (31) à effet de champ est alimenté par un circuit (36) d'alimentation, découplé du signal reçu, par l'intermédiaire de l'ame (34) d'un câble coaxial (35) constituant une ligne (8) haute fréquence de liaison du circuit (30) de réception à des moyens (9) de traitement de l'appareil d'imagerie.

**Patentansprüche**

1. Antenne (7) zum Erzeugen von Bildern der Augenhöhle durch ein Bildererzeugungsgerät (1—11) mittels magnetischer Kernresonanz, dadurch gekennzeichnet, daß sie umfaßt:
eine gerade Zahl von leitenden, konzentrischen, in Reihe (18) geschalteten Schleifen (12; 13);
einen Abgleichkondensator (19), der zwischen den miteinander nicht verbundenen Enden (21, 20) dieser Schleifen (12; 13) angeschlossen ist;
und eine Empfangsschaltung (30) einer hohen Eingangsimpedanz, die zwischen dem Mittelpunkt (18) der Schleifen (12; 13) und einer der Klemmen des Kondensators (19) angeschlossen ist.

2. Antenne nach Anspruch 1, dadurch gekennzeichnet, daß die gerade Zahl gleich 2 ist.

3. Antenne nach Anspruch 2, dadurch gekennzeichnet, daß die beiden Schleifen (12; 13) in einer selben Ebene enthalten sind und sich überlappen, wobei jede Schleife (12; 13) einen Außenbogen (14; 16) sowie einen Innenbogen (15; 17) umfaßt, wobei der Mittelpunkt (18) der Schleifen der Verbindung beider Innenbögen (15; 17) entspricht.

4. Antenne nach Anspruch 2, dadurch gekennzeichnet, daß die Schleifen (23; 24) übereinanderliegen und beiderseits einer Trägerplatte (25) senkrecht zueinander angeordnet sind.

5. Antenne nach einem der Ansprüche 1 bis 4, dadurch gekennzeichnet, daß die Empfangsschaltung (30) einen Feldeffekt-Transistor (31) in Emitter-Basisschaltung umfaßt.

6. Antenne nach Anspruch 5, dadurch gekennzeichnet, daß der Feldeffekt-Transistor (31) über eine Speiseschaltung (36) gespeist wird, die von dem empfangenen Signal entkoppelt ist, über die Seele (34) eines koaxialen Kabels (35), das eine Hochfrequenzleitung (8) zum Verbinden der Empfangsschaltung (30) mit Mitteln (9) zur Verarbeitung des Bildererzeugungsgeräts bildet.

**Claims**

1. An antenna for producing an image of the ocular orbit by means of an nuclear magnetic resonance apparatus (1—11), characterized in that it comprises:
an even number of conducting loops (12 and 13) which are concentric and placed in series (18),
a matching capacitor (19) connected between the non-united ends (21 and 20) of these loops (12 and 13),
and a high impedance receiving circuit (30) connected between the center point (18) of these loops (12 and 13) and one of the terminals of the capacitor (19).

2. The antenna as claimed in claim 1, characterized in that the even number is equal to 2.

3. The antenna as claimed in claim 2, characterized in that the two loops (12 and 13) are contained in the same plane and straddle each other, each loop (12 and 13) comprising an exterior arc (14 and 16), and an interior arc (15 and 17), the center point (18) of the loops corresponding to the connections of these two interior arcs (15 and 17).

4. The antenna as claimed in claim 2, characterized in that the loops (23 and 24) are superposed and are placed perpendicularly to each other on the two sides of a support plate (25′).

5. The antenna as claimed in any one of the claims 1 through 4, characterized in that the receiving circuit (30) comprises a field effect transistor (31) in a common emitter circuit.

6. The antenna as claimed in claim 5, characterized in that field effect transistor (31) is supplied by a feed circuit (36), which is decoupled from the received signal, by the intermediary of the core (34) of a coaxial cable (35) constituting a high frequency connection line of the receiving circuit (30) for connection with processing means (9) of the image producing apparatus.

FIG_1

# FIG_2

# FIG_3

# FIG_4

2